Europäisches Patentamt

European Patent Office

Office européen des brevets

(19)

(11) Veröffentlichungsnummer: **0 193 836**

**A1**

(12) # EUROPÄISCHE PATENTANMELDUNG

(21) Anmeldenummer: 86102391.9

(22) Anmeldetag: 24.02.86

(51) Int. Cl.4: **G11C 8/00** , **H03H 17/06**

(30) Priorität: 25.02.85 DE 3506561

(43) Veröffentlichungstag der Anmeldung:
10.09.86 Patentblatt 86/37

(84) Benannte Vertragsstaaten:
AT BE DE FR GB IT NL SE

(71) Anmelder: **Siemens Aktiengesellschaft Berlin und München**
**Wittelsbacherplatz 2**
**D-8000 München 2(DE)**

(72) Erfinder: **Tielert, Reinhard, Dr.**
**Lehrer-Götz-Weg 24**
**D-8000 München 82(DE)**
Erfinder: **Zehner, Bernd, Dr.**
**Therese-Giehse-Allee 23**
**D-8000 München 83(DE)**

(54) **Schaltungsanordnung mit einer matrixförmigen Speicheranordnung zur digitalen Filterung von Bildsignalen in Zeilen- und Spaltenrichtung.**

(57) Eine Schaltungsanordnung mit einer matrixförmigen Speicheranordnung zur digitalen Flterung von Bildsignalen in Zeilen-und Spaltenrichtung enthält als speichernde Elemente an sich bekannte 3-Transistorzellen mit überlappenden Schreib-/Lesezyklen. Es ist ein vom Eingangstakt der einlaufenden Bildsignale taktgesteuerter, kontinuierlich fortschaltbarer, jederzeit rücksetzbarer Zeilenwähler ($P_1...P_n$) vorgesehen, der je zwei in der Phase gegeneinander versetzte Signalausgänge je Wählschritt aufweist, die jeweils eine Schreibwortleitung (ws) bzw. eine Lesewortleitung (wl) ansteuern, welche je Zeile der Matrix vorgesehen sind. Je Spalte sind zwei getrennte Bitleitunge, nämlich eine Schreibbitleitung (bs) und eine Lesebitleitung (bl) vorgesehen, die jeweils mit allen Speicherzellen einer Spalte zusammengeschaltet sind. Je Spalte ist ein von der Lesebitleitung abtrennbarer, speichernder Verstärker ($A_1...A_m$) vorgesehen, dessen Eingang (i) mit der Lesebitleitung (bl) der ihm zugeordneten Spalte und dessen Ausgang (o) mit der Bitschreibleitung (bs) der ihm nachgeordneten Spalte verbunden ist und als ein ihm zugeordneter Datenausgang ($Z_1...Z_m$,) dient. Ein Rücksetzeingang $\overline{Reset}$ ist mit Setzeingängen (a, $\overline{s}$ ) eines ersten Gliedes ($P_1$) des Zeilenwählers sowie mit den Rücksetzeingängen ($\overline{r}$ ) der restlichen Glieder ($P_1...P_n$) des Zeilenwählers verbunden. Der zeitliche Abstand zwischen Rücksetzimpulsen ($\overline{Reset}$ ) wird derart gewählt, daß er gleich der geforderten Verzögerungszeit ist, welche zwischen einem unverzögerten Datenausgang ($Z_0$) und einem ersten verzögerten Datenausgang ($Z_1$) eingestellt werden soll. Entsprechend der Wortbreite der Bilddaten sind eine Vielzahl von derartigen matrixförmigen Speicheranordnungen vorgesehen, für die der Zeilenwähler ($P_1... P_n$ ) gemeinsam angeordnet ist, wobei jeweils ein Speicherblock ein Bit des Bilddatenwortes aufnimmt und als das jeweils entsprechende Bit von mehreren, unterschiedlich verzögerten Ausgangsdatenwörtern bereitstellt. Schließlich ist eine arithmetische Einheit vorgesehen, in der Datenausgänge zum Erreichen der geforderten Filterfunktion in einer Anordnung kaskadierter Verknüpfungsglieder verknüpft, d.h. addiert bzw. subtrahiert werden.

FIG2

EP 0 193 836 A1

Schaltungsanordnung mit einer matrixförmigen Speicheranordnung zur digitalen Filterung von Bildsignalen in Zeilen-und Spaltenrichtung.

Die vorliegende Erfindung betrifft eine Schaltungsanordnung mit einer matrixförmigen Speicheranordnung zur digitalen Filterung von Bildsignalen in Zeilen-und Spaltenrichtung zum Zweck einer Verminderung der Redundanz in den Bildsignalen.

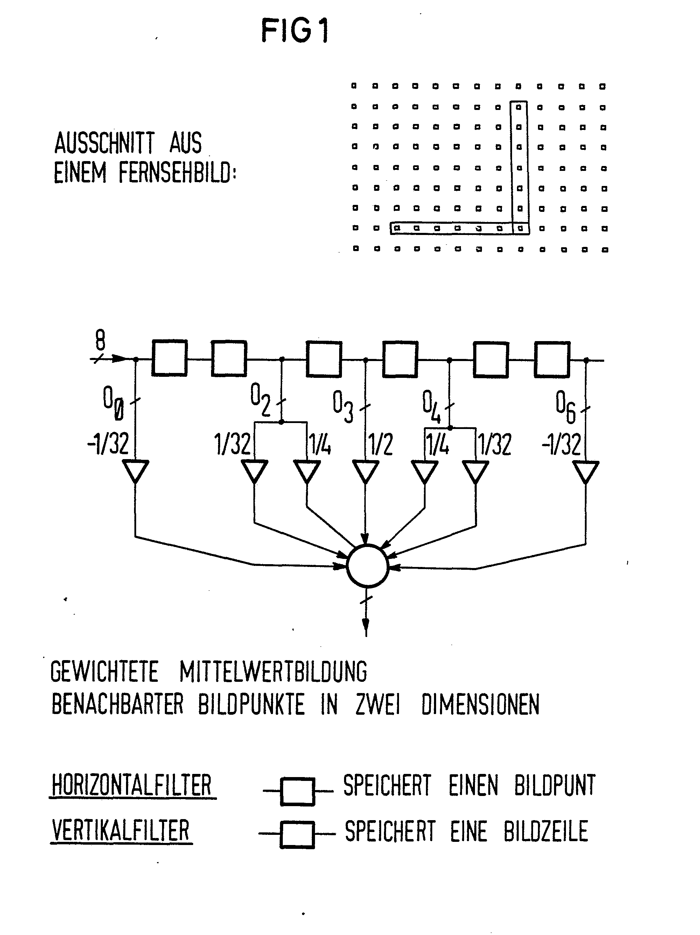

Die digitale Übertragung von Farbbildsignalen über die Kanäle der Pulscode-Modulation(PCM)-Hiercharchie eines Übertragungsnetzes erfordert eine Datenreduktion durch Herabsetzen der Abtastraten aus Gründen der Beschaffenheit der betreffenden Übertragungskanäle. Ein jeweils erforderlicher Codec enthält deshalb digitale Filter zur Dezimierung bzw. Interpolation. In den Filtern müssen horizontal bzw. vertikal benachbarte Bildpunkte -im folgenden als Ordnungen $O_0$, $O_1$...$O_6$ bezeichnet-binär gewichtet und aufaddiert werden (vergl. Fig. 1). Für die Filterung in vertikaler Richtung müssen hierzu sechs Bildzeilen in Zeilenspeichern bereitgehalten werden.

Es sind bereits digitale Filter dieser Art für ein Versuchssystem auf der Basis von Standardbausteinen realisiert worden. Zur Realisierung der erforderlichen Zeilenspeicher werden dabei statische CMOS-RAMs verwendet, wobei der Zugriff auf die Zeilenspeicherzellen durch Hochzählen eines Zählers und Decodieren des Zählerstandes erfolgt. Eine für derartige digitale Filter erforderliche Arithmetikeinheit ist aus kaskadierten Addierern und Registern zusammengesetzt. Der Platzbedarf und die Kosten bei einer derartigen Realisierung sind verhältnismäßig hoch. Die erreichbaren Datenraten sind durch die Zykluszeit der hier unzweckmäßigen statischen Speicherzellen begrenzt. Außerdem ist der Speicherzugriff über einen Decoder bei der im vorliegenden Fall erforderlichen zyklischen Betriebsweise umständlich und daher ineffizient. Schließlich ist eine Integration dieser Lösung wegen der sich ergebenden Unregelmäßigkeit der Schaltungsstruktur wenig geeignet.

Der vorliegenden Erfindung liegt die Aufgabe zugrunde, eine regelmäßig strukturierte, flächengünstige und auch bei höheren Datenraten brauchbare Schaltungsanordnung auf der Grundlage weniger, angepaßter Grundzellen für den eingangs genannten Zweck zu schaffen.

Zur Lösung dieser Aufgabe für die vorliegende Erfindung wird eine Schaltungsanordnung mit einer matrixförmigen Speicheranordnung zur digitalen Filterung von Bildsignalen in Zeilen-und Spaltenrichtung vorgeschlagen, die durch die in dem Patentanspruch 1 angegebenen Merkmale gekennzeichnet ist.

Vorteilhafte Weiterbildungen der vorliegenden Erfindung sind durch die in den Unteransprüchen angegebenen Merkmale gekennzeichnet.

Im folgenden wird die vorliegende Erfindung anhand mehrerer bevorzugter Ausführungsbeispiele für die vorliegende Erfindung betreffender Figuren im einzelnen erläutert.

Fig.1 zeigt eine Darstellung, die das Prinzip für die beiden Bildfilter, nämlich das Horizontalfilter, das sechs Bildpunkte speichert, und das Vertikalfilter, das sechs Bildzeilen speichert, zeigt.

Fig.2 zeigt ein Blockschaltbild einer matrixförmigen Speicheranordnung, die einen wesentlichen Teil der erfindungsgemäßen Schaltungsanordnung bildet.

Fig. 3 zeigt ein Impuls/Zeit-Diagramm zur Erläuterung der Arbeitsweise der in Fig. 2 gezeigten matrixförmigen Speicheranordnung.

Fig. 4 zeigt die in Fig. 2 enthaltene symbolische Darstellung und ein Prinzipschaltbild einer 3-Transistorspeicherzelle, wie sie nxm-fach in der Speicheranordnung gemäß Fig. 1 verwendet wird.

Fig. 5 zeigt die in Fig. 2 enthaltene symbolische Darstellung sowie ein Prinzipschaltbild eines Regenerators (Verstärkerschaltung), wie sie m-fach in der Schaltungsanordnung gemäß Fig. 2 verwendet wird.

Fig. 6 zeigt ein Blockschaltbild einer Anordnung, in der gemäß der Wortbreite der zu verzögernden Datenwörter eine Vielzahl von Speicherblöcken Sp0, Sp1...SP7 und ein zentraler Zeilenwähler vorgesehen sind.

Fig. 7 zeigt die Struktur einer Arithmetikeinheit bei Anordnung der Eingänge nach steigenden Koeffizienten 1/32, 1/4, 1/2 mit einer erforderlichen Wortbreite von 10 bit, wobei die gezeigten Maschenknotenaddierer und die Blöcke T Register symbolisieren

Fig. 8 zeigt die in Fig. 2 enthaltene symbolische Darstellung einer Zeilenwählerstufe sowie deren Prinzipschaltbild, welche Stufe der Schaltungsanordnung gemäß Fig. 2 n-fach verwendet werden.

Fig. 9 zeigt eine Hardware-Konfiguration der Struktur gemäß Fig. 7 für den Fall, daß sogenannte Carry-Safe-Addierer bei Zweierkomplement-Darstellung der zu verarbeitenden Datensignale verwendet werden, wobei die Symbole L für ein Latch, R für ein Register und D für ein Doppelregister (für zwei Variable) stehen.

Fig. 10 zeigt eine weitere Hardware-Konfiguration der Struktur nach Fig. 7, die anstelle von Carry-Safe-Addierern sog. Carry-ripple-Addierer verwendet, wobei die Symbole L für ein Latch, R für ein Register und D für ein Doppelregister (für zwei Variable) stehen.

Fig. 11 zeigt die Konfiguration eines Paralleladdierers für 10 bit Wortbreite, wobei das Symbol R jeweils für ein Register und das Symbol D für ein Doppelregister (für zwei Variable) verwendet ist.

Fig. 12 zeigt eine symbolhafte Darstellung und ein Blockschaltbild eines in der erfindungsgemäßen Schaltungsanordnung nach Fig. 11 verwendeten Verknüpfungsblocks für vier Eingangsvariable und zwei Ausgangsvariable.

Fig. 13 zeigt eine symbolische Darstellung und ein Blockschaltbild für einen in der erfindungsgemäßen Schaltungsanordnung nach Fig. 11 verwendeten weiteren Verknüpfungsblock für zwei Eingangsvariable und zwei Ausgangsvariable.

Fig. 14 zeigt einen der in Fig. 11 enthaltenen Verknüpfungsbäume, wie er sich n-mal in dieser Struktur wiederholt.

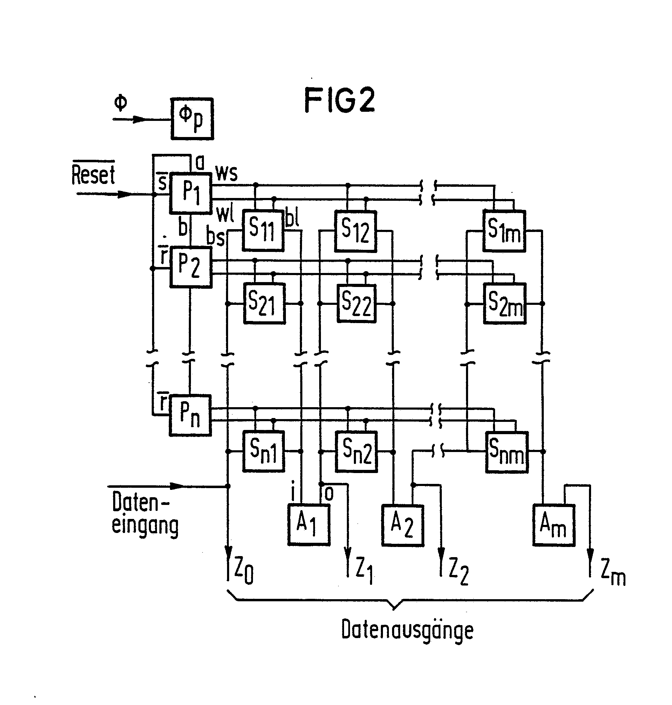

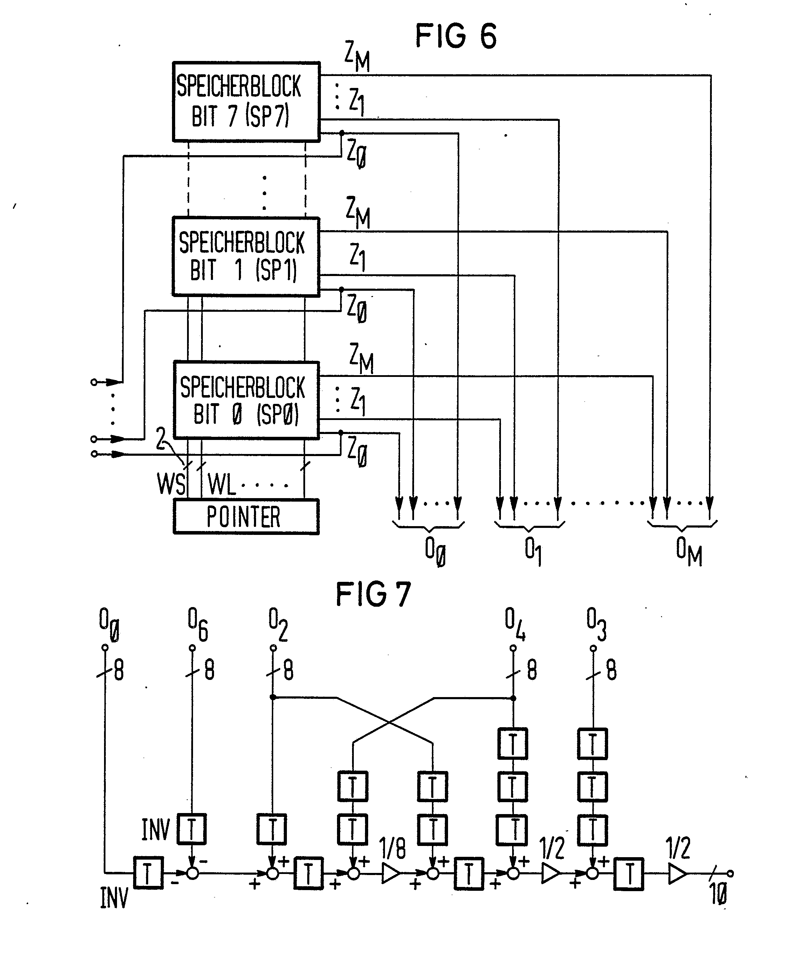

Die für die erfindungsgemäße Schaltungsanordnung vorgesehene **Verzögerungseinheit** basiert auf einer Schaltungsanordnung, wie sie in der bereits erläuterten Fig. 2 dargestellt ist. Die in Fig. 2 gezeigte Schaltungsanordnung stellt einen sog. First-In-First-Out-Pufferspeicher (FIFO) variabler Länge für 1 Bit dar. Der Zugriff erfolgt zyklisch über einen Zeilenwähler $P_1...P_n$ . Mit jedem Arbeitstakt wird die Information in der gerade aktivierten Zeile einer Spalte nach rechts verschoben. Die Verzögerungszeit ist über ein Rücksetzsignal $\overline{\text{Reset}}$ für diesen Zeilenwähler in weiten Grenzen einstellbar. Für jedes Bit eines Eingangsdatenwortes wird ein derartiger Speicherblock, wie dies in Fig. 6 gezeigt ist, benötigt. Die Spaltenzahl pro Block ist durch die größte der in .dem Filter benötigten Ordnungen gegeben, und die Zeilenzahl entspricht der Anzahl der Punkte pro Bildzeile.

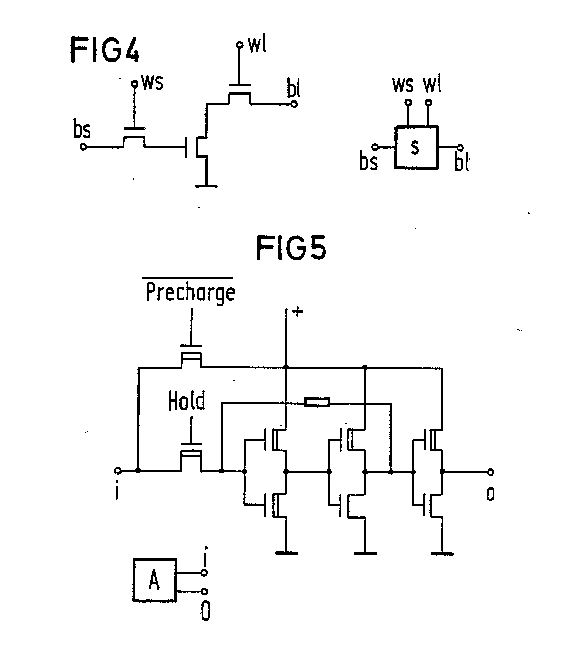

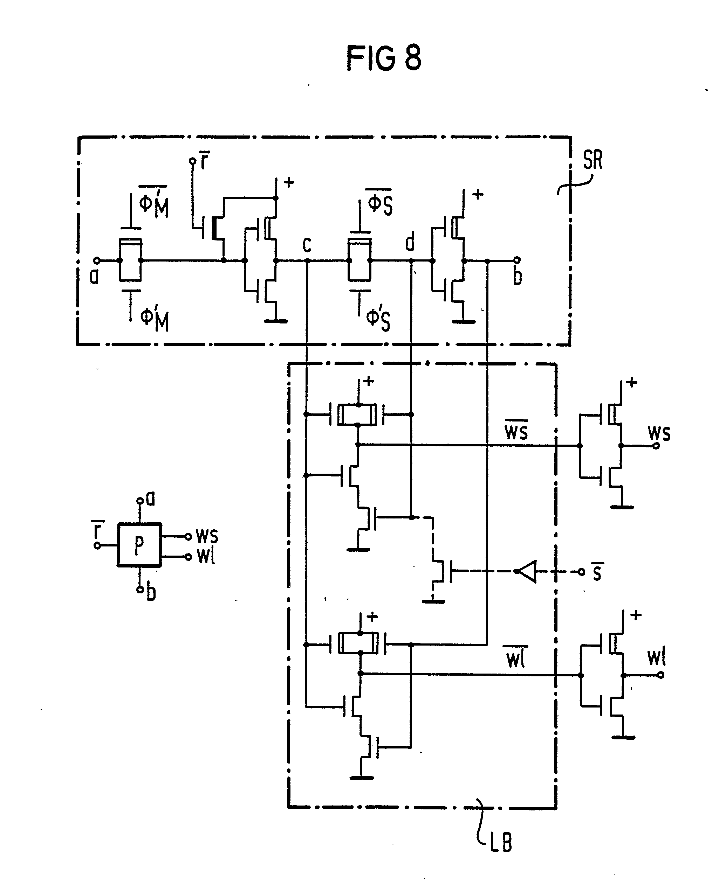

Als speichernde Elemente in einer derartigen Speicheranordnung sind an sich bekannte 3-Transistorzellen mit überlappenden Schreib-/Lesezyklen (vergl. Fig. 4) vorgesehen. Der Zeilenwähler $P_1...P_n$ ist ein vom Eingangsdatentakt der einlaufenden Bildsignale taktgesteuerter, kontinuierlich fortschaltbarer und jederzeit rücksetzbarer Zeilenwähler, der je zwei in der Phase gegeneinander versetzte Signalausgänge je Wählschritt aufweist, die jeweils eine Schreibwortleitung ws bzw . eine Lesewortleitung wl ansteuern, welche je Zeile der Matrix vorgesehen sind (vergl. Fig. 8). Je Spalte sind zwei getrennte Leitungen, nämlich eine Schreibbitleitung bs und eine Lesebitleitung bl, vorgesehen, die jeweils mit allen Speicherzellen einer Spalte zusammengeschaltet sind. Je Spalte ist ein von der Lesebitleitung abtrennbarer, speichernder Verstärker $A_1...A_m$ vorgesehen, dessen Eingang i mit der Lesebitleitung bl der ihm zugeordneten Spalte und dessen Ausgang o mit der Schreibbitleitung bs der ihm nachgeordneten Spalte verbunden ist und als ein ihm zugeordneter Datenausgang $Z_1...Z_m$ dient. Ein Dateneingang für die zu verzögernden Bildsignale ist mit der Schreibbitleitung bs der ersten Spalte und einem unverzögerten Datenausgang $Z_0$ verbunden. Ein Rücksetzeingang $\overline{\text{Reset}}$ ist mit Setzeingängen a, $\overline{s}$ eines ersten Gliedes $P_1$il des Zeilenwählers sowie mit den Rücksetzeingängen $\overline{r}$ der restlichen Glieder $P_2...P_n$ des Zeilenwählers verbunden. Der zeitliche Abstand zwischen den Rücksetzimpulsen $\overline{\text{Reset}}$ wird derart gewählt, daß er gleich der geforderten Verzögerungszeit ist, welche zwischen dem unverzögerten Datenausgang $Z_0$ und dem ersten verzögerten Datenausgang $Z_1$ eingestellt werden soll.

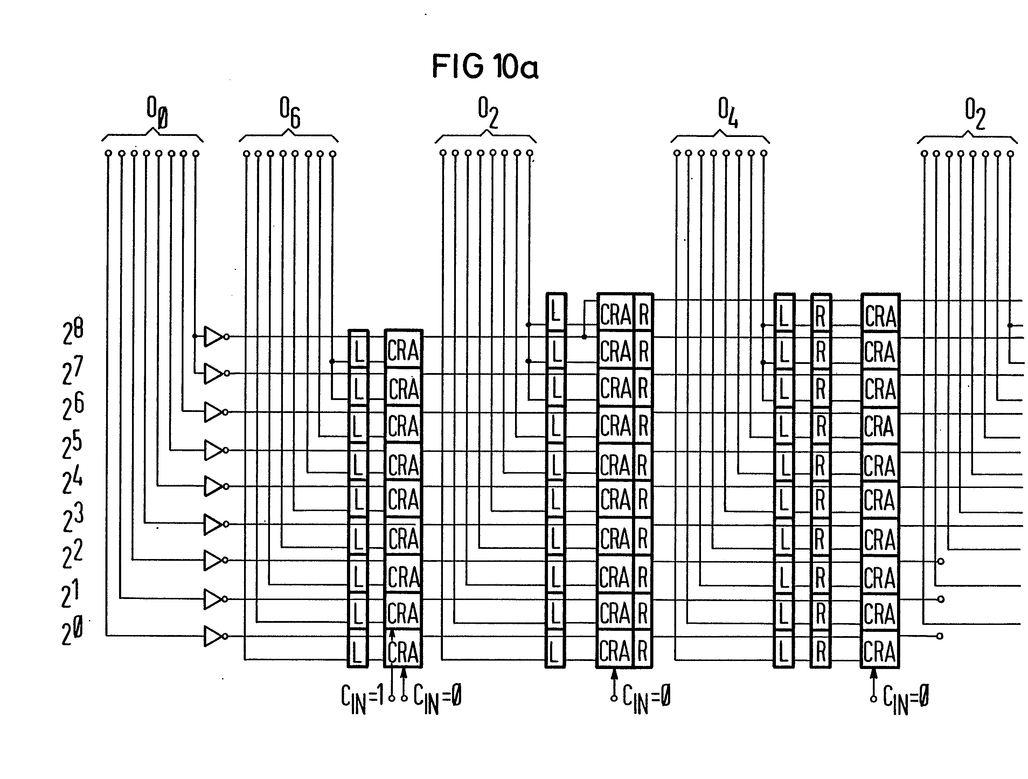

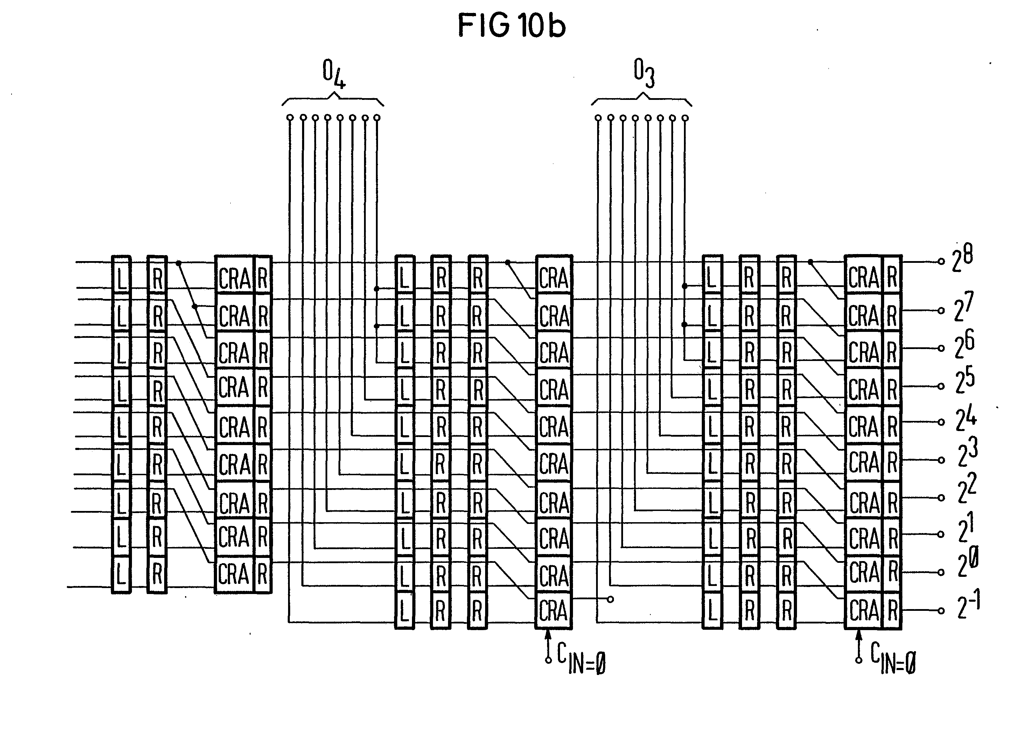

Wie bereits erläutert, sind entsprechend der Wortbreite der Bilddaten eine Vielzahl von derartigen matrixförmigen Speicheranordnungen, nämlich Speicherblöcke $SP_0...SP_7$ vorgesehen (vergl. Fig. 6), für die der Zeilenwähler $P_1...P_n$ gemeinsam angeordnet ist, wobei jeweils ein Speicherblock 1 Bit des Bilddatenwortes aufnimmt und als das jeweils entsprechende Bit von mehreren unterschiedlich verzögerten Ausgangsdatenwörtern $O_0...O_n$) bereitstellt. Außerdem ist eine arithmetische Einheit vorhanden (vergl. Fig. 7, Fig. 9, Fig.10, Fig. 11, Fig. 14), in der die Datenausgänge $O_0...O_m$ zum Erreichen der geforderten Filterfunktion in einer Anordnung kaskadierter Verknüpfungsglieder derart verknüpft, d.h. addiert bzw. subtrahiert, werden, daß zunächst zwei Ausgänge $O_i$ mit dem betragsmäßig kleinsten Koeffizienten miteinander verknüpft werden, das Resultat nach gegebenenfalls entsprechend der Filterfunktion erforderlicher Gewichtung mit dem Ausgang $O_i$ mit dem betragsmäßig nächstgrößeren Koeffizienten verknüpft wird, das Resultat gegebenenfalls wiederum gewichtet wird, und so fort, wobei zum Anpassen sich unterschiedlich ergebender Laufzeiten in dieser kaskadierten Anordnung digitale Verzögerungsglieder T an den entsprechenden Stellen vorgesehen sind.

In Fig. 6 ist gezeigt, wie durch Vervielfachen von Speicherblöcken der zuvor beschriebenen Art eine Verzögerungseinheit zusammenzustellen ist, welche die Ordnungen $O_0, O_2...O_6$ für das Filter gemäß Fig. 1 bereitstellt. Jeder der Speicherblöcke $SP_0...SP_7$ stellt dabei ein Speicherfeld dar, wie es in Fig. 2 gestrichelt eingerahmt gezeigt ist. Die einzelnen Speicherblöcke können dabei zu einem großen Speicherfeld verschmolzen werden, und der Zugriff kann über einen diesem gemeinsam zugeordneten Zeilenwähler erfolgen. Das externe Rücksetzsignal $\overline{\text{Reset}}$ legt die Betriebsart des Filters fest. Kommt der Rücksetzimpuls jeweils nach einer Zeile, so stehen an den Ausgängen der in Fig. 6 gezeigten Anordnung vertikal benachbarte Bildpunkt-Bits bereit. Wird dagegen mit jedem Taktimpuls rückgesetzt, so erscheinen dort die horizontal benachbarten Bildpunkt-Bits. In diesem Fall bleibt der größte Teil des Speicherfeldes ungenutzt.

Fig. 4 zeigt, wie bereits erläutert, eine Darstellung der verwendeten 3-Transistorzelle, deren Prinzip darauf beruht, daß die zu speichernde Information dynamisch auf dem Gate eines MOS-Transistors (des mittleren der drei Transistozelle gespeichert wird. Diese an sich bekannte 3-Transistoren) wird, wie durch die Klemmenbezeichnung angegeben, in einer speziellen Betriebsart verwendet, bei der zum Lesen und Schreiben getrennte Bitleitungen benutzt werden (vergl. Fig. 2), wodurch sich die Möglich des Lesens und Schreibens in einem einzigen Taktzyklus ergibt.

Fig. 5 zeigt, wie bereits erläutert, eine Darstellung eines Regenerators oder Verstärkers. Die Aufgabe dieses Regenerators besteht darin, das auf der seinem Eingang i zugeordneten Lesebitleitung bl auftretende geschwächte Lesesignal auf den Normalpegel zu verstärken und dieses auf die seinem Ausgang o zugeordnete, kapazitiv stark belastete Schreibbitleitung bs auszugeben. Die Schaltung dieses Regenerators enthält eine dreistufige Inverteranordnung mit einem darin enthaltenen Mitkopplungspfad. Der Inverteranordnung ist ein Schalter vorgeordnet, der jedesmal dann, wenn die Lesebitleitung für den nächsten Taktzyklus vorgeladen wird -gesteuert von dem Hold-Signal-die Inverteranordnung von dem Eingang i abtrennt und dadurch die eingespeicherte Information festhält. Dabei wird das Vorladen von einem durch das $\overline{\text{Precharge}}$-Signal gesteuerten weiteren Schalter bewirkt.

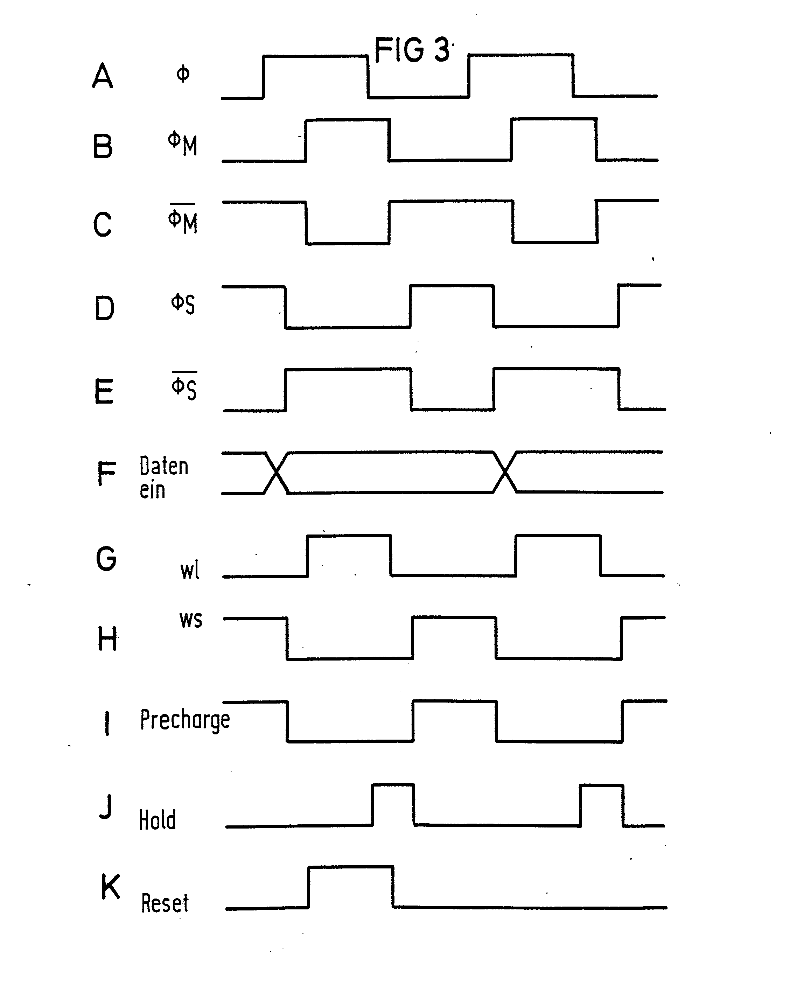

Fig. 8 zeigt, wie bereits erläutert, die Darstellung einer Zeilenwählerstufe P. In einem Schieberegisterblock SR sind zwei dynamische Registerstufen, die durch mittels Hilfstakte $\overline{\varnothing'}_M$ , $\varnothing_M; \overline{\varnothing}_S$ , $\varnothing_S$ gesteuerte Schalter voneinander bzw. von dem Signaleingang a trennbar sind, vorgesehen. Die Hilfstakte $\overline{\varnothing'}_M$ und $\varnothing'_M$ entsprechen den Hilfstakten $\overline{\varnothing}_M$ und $\varnothing_M$ gemäß dem in Fig. 3 gezeigten Impuls/Zeit-Diagramm. Sie stellen allerdings Ergebnissignale einer Verknüpfung der betreffenden in Fig. 3 gezeigten Signale mit dem Reset-Signal dar. Diese Verknüpfung bewirkt ein Schließen des Schalters am Eingang des Schieberegisterblocks SR für die Dauer des Reset-Signals. In einem Logikblock LB sind zwei Verknüpfungsglieder vorgesehen, die die an den Punkten c, d, b auftretenden Signale nach folgenden Funktionen miteinander verknüpfen:

$$\overline{ws} = \overline{c \wedge d}$$

$$\overline{wl} = c \wedge d$$

Die Ausgangssignale $\overline{ws}$ und $\overline{wl}$ des Logikblocks LB werden mittels invertierender Treiber auf die Schreibwortleitung ws bzw. die Lesewortleitung wl der zugehörigen Zeile der matrixförmigen Speicheranordnung geschaltet. Es für die

Stufen $P_2...P_n$ des Zeilenwählers gemäß Fig. 2 jeweils ein Reset-Eingang $\overline{r}$ vorgesehen. An dessen Stelle tritt bei der Stufe $P_1$ ein Setzeingang $\overline{s}$, wie dies in Fig. 8 gestrichelt angedeutet ist.

Wie bereits erläutert, zeigt Fig. 3 ein Impuls/Zeit-Diagramm zur Verdeutlichung der Arbeitsweise der erfindungsgemäßen Schaltungsanordnung.

In Fig. 3A ist der an die Taktsteuerung gelegte Grundtakt $\emptyset$ dargestellt. Daraus abgeleitete Hilfstakte zur Steuerung des Zeilenwählers (vergl. auch Fig. 8), nämlich $\emptyset_M$, $\overline{\emptyset}_M$ , $\emptyset_S$ und $\overline{\emptyset}_S$ sind in Fig. 3B, 3C, 3D bzw. 3E gezeigt. Fig. 3F zeigt die Phasenlage des Eingangsdatenstroms in bezug auf den Grtundtakt $\emptyset$. In Fig. 3G und Fig. H sind die Ausgangssignale des Zeilenwählers, nämlich das Lesewort- bzw. das Schreibwortleitungssignal wl bzw. ws, dargestellt. In Fig. 3I und Fig. 3J sind ein Precharge-Signal bzw. ein Hold-Signal gezeigt, die zur Steuerung der Regeneratorschaltungen (vergl. auch Fig. 5) verwendet werden. Fig. 3K zeigt schließlich die Phasenlage des erforderlichen Reset-Signals in bezug auf den Grundtakt $\emptyset$.

Das Reset-Signal, das dem Rücksetzeingang $\overline{Reset}$ zugeführt wird, wird vorzugsweise mit den Eingangssignalen bereitgestellt. Es ist außerdem vorgesehen, daß aus der Schaltungsanordnung nur diejenigen Datenausgänge herausgeführt sind, die für die betreffende geforderte Filterfunktion der Schaltungsanordnung notwendig sind.

Für die **Arithmetikeinheit** ist eine Lösung auf folgender Grundlage vorgesehen:

-Pipeline-Verarbeitung und parallele Organisation zur Bewältigung der hohen Datenrate;

-"Bitscheiben"-Technik und Zellenkonzept im Hinblick auf eine platzsparende, reguläre Realisierung.

Die Koeffizienten der Arithmetikeinheit sind als Summe von Zweierpotenzen darstellbar, die Gewichtung ist daher durch stellenversetztes Anschließen der Operanden zu verwirklichen.

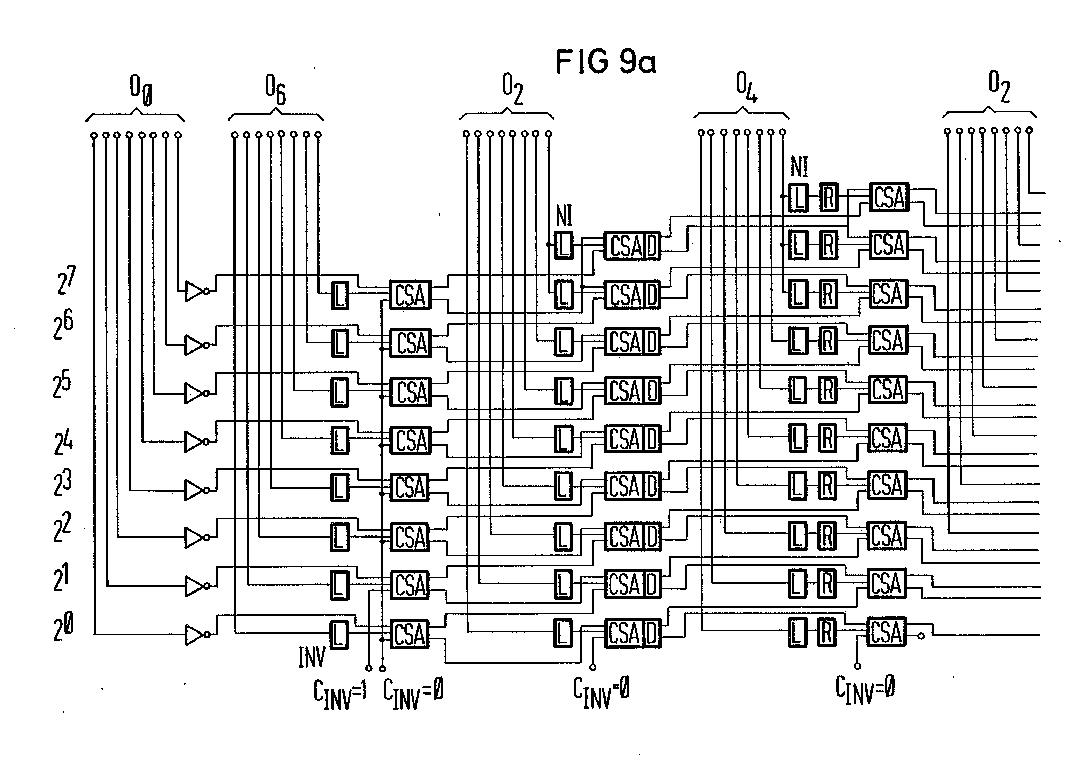

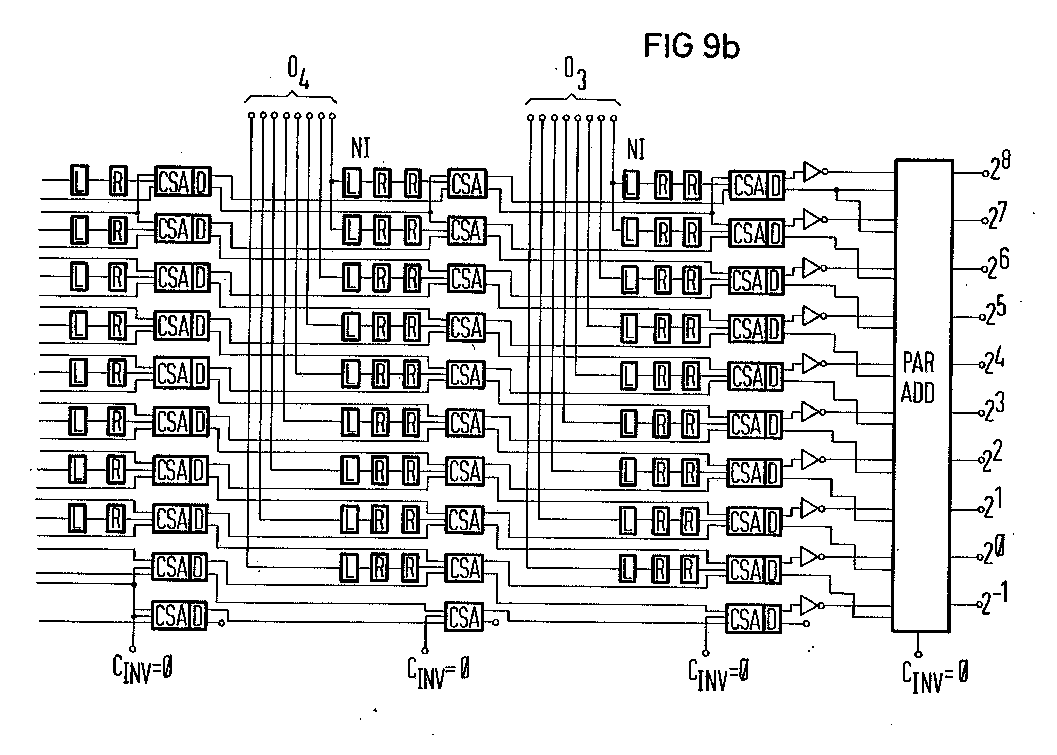

Fig. 7 zeigt eine mögliche Struktur der Arithmetikeinheit. Die Eingangsleitungsbündel sind hier nach steigenden Beträgen der zugehörigen Koeffizienten angeordnet, diese selbst treten in kaskadierter Form nur mehr in dem horizontalen Zweig auf. Diese vorgeschlagene Lösung hat den Vorteil, daß in bestimmten Fällen auf Nach-Komma-Stellen verzichtet werden kann. Dies bedeutet geringe Wortbreiten in der Arithmetikeinheit (in dem vorliegenden Fall l0 bit) und damit einen geringen Flächenbedarf. Für eine eindeutige Abbildung dieser Struktur auf einer Hardware-Konfiguration sind weitere Festlegungen erforderlich. Wegen der einfachen Darstellung der Subtraktion wird im Zweierkomplement-Code gerechnet. Für die Addition ist vorzugsweise das Carry-Safe-Konzept vorgesehen, um eine noch bei hohen Datenraten sinnvolle Lösung zu erzielen. Unter diesen Voraussetzungen ergibt sich eine vorteilhafte Konfiguration, wie sie in Fig. 9 gezeigt ist.

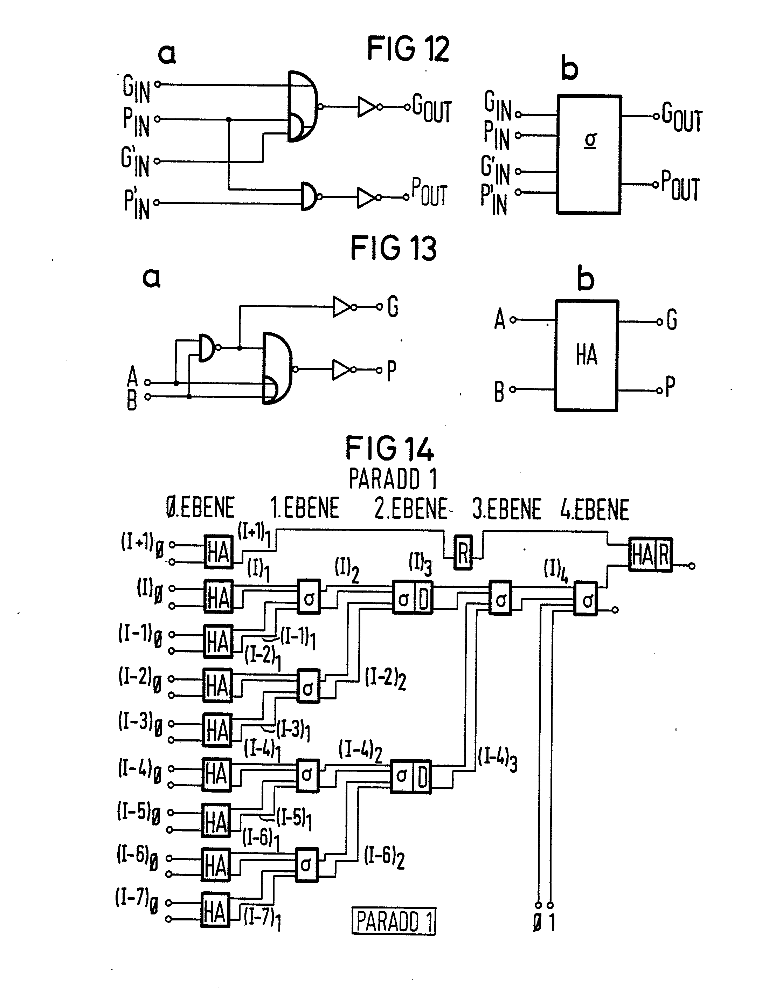

Die notwendige abschließende Aufarbeitung der Überträge (carries) wird in einem Pipeline-Paralleladdierer PARADD durchgeführt. Die hierfür verwendeten beiden Grundzellen sind, wie bereits erläutert, in Fig. 12 und Fig. 13 angezeigt. Diese Grundzellen lassen sich auf verschiedene Arten zu einer Addierer-Konfiguration zusammenstellen.

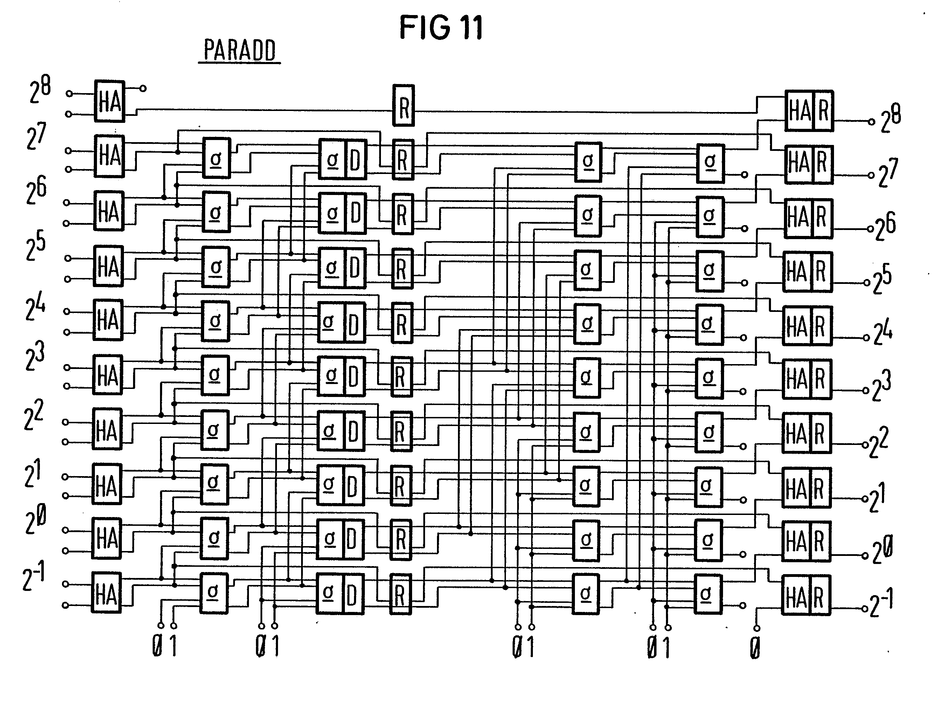

Fig. 11 und Fig. 14 zeigen ein gegenüber bekannten Anordnungen erheblich flächengünstigeres Konzept für diese Addierer-Konfiguration. Zur Verdeutlichung der Verknüpfungsstruktur dient der hervorgehobene Teil gemäß Fig. 14. Der Pipeline-Paralleladdierer PARADD enthält

außer Halbaddierern HA an sich bekannte Verknüpfungsglieder $\sigma$ für vier Eingangsvariable $G_{IN}$, $P_{IN}$, $G'_{IN}$ und $P'_{IN}$ und zwei Ausgänge $G_{OUT}$ und $P_{OUT}$ mit den logischen Funktionen

$$G_{OUT} = G_{IN} \vee (G'_{IN} \wedge P_{IN})$$

$$P_{OUT} = P_{IN} \wedge P'_{IN}.$$

Des weiteren ist erfindungsgemäß vorgesehen, daß zur Erzeugung des Resultats der i-ten Stelle in einer ersten Ebene jeweils paarweise die Eingangsvariablen $(i)_1$ mit $(i-1)_1$, $(i-2)_1$ mit $(i-3)_1$, $(i-4)_1$ mit $(i-5)_1$ und so fort nach diesen logischen Funktionen verknüpft werden, daß in einer zweiten Ebene die Resultate dieser Verknüpfung wiederum als Eingangsvariable für paarweise Verknüpfungen $(i)_2$ mit $(i-2)_2$, $(i-4)_2$ mit $(i-6)_2$ und so fort nach diesen logischen Funktionen verknüpft werden, daß soviele Verknüpfungsebenen dieser Art vorgesehen sind, daß nur noch ein Resultat als Rest übrigbleibt, daß die Eingangsvariablen $G_{IN}$, $P_{IN}$ , $G'_{IN}$, $P'_{IN}$ für die erste Ebene durch eine Eingangsgruppe mit Halbaddierern HA bereitgestellt werden, wobei die Eingangsvariablen $G_{IN}$, $P_{IN}$ durch die Halbaddierer-Ausgänge G, P der i-ten Stelle und die Eingangsvariablen $G'_{IN}$, $P'_{IN}$ durch die Halbaddierer-Ausgänge G, P der (i-1)-ten Stelle gebildet werden und so weiter. Die Summenbits, nämlich die Bits des Ausgangsdatenwortes, werden aus den Resultatbits der letzten Ebene von Verknüpfungsgliedern und Ausgangsvariablen der Eingangs-Halbaddierergruppe derart gebildet, daß der Halbaddierer HA der (i+1)-ten Stelle mit dem Ausgangssignal $G_{OUT}$ des Verknüpfungsgliedes der i-ten Stelle und dem Ausgangssignal P des Eingangs-Halbaddierers HA der (i+1)-ten Stelle belegt wird und so weiter. Die in diesem Verknüpfungsschema nicht benutzten Eingänge der Verknüpfungsglieder werden auf entsprechende feste Hilfspotentiale, nämlich $G'_{IN} = 0$ und $P'_{IN} = 1$ gelegt.

Eine Weiterbildung der Erfindung sieht vor, daß in der arithmetischen Einheit sogenannte Carry-Ripple-Addierer als Verknüpfungsglieder enthalten sind, wobei die zu verknüpfenden Daten ebenfalls im Zweierkomplement dargestellt sind.

Die Auswahl des Carry-Save-Prinzips oder des Carry-Ripple-Prinzips wird durch den Anwendungsfall bzw. die Voraussetzungen für die hardwaremäßige Realisierung der gesamten Schaltungsanordnung bestimmt.

Die erfindungsgemäße beschriebene Schaltungsanordnung ist aufgrund ihrer regulären Schaltungsstruktur besonders dafür geeignet, daß sie als monolithisch integrierte MOS-Schaltung realisiert wird.

**Ansprüche**

1. Schaltungsanordnung mit einer matrixförmigen Speicheranordnung zur digitalen Filterung von Bildsignalen in Zeilen-und Spaltenrichtung,

dadurch **gekennzeichnet,**

-daß als speichernde Elemente an sich bekannte 3-Transistorzellen mit überlappenden Schreib-/Lesezyklen vorgesehen sind,

-daß ein vom Eingangsdatentakt der einlaufenden Bildsignale taktgesteuerter, kontinuierlich fortschaltbarer, jederzeit rücksetzbarer Zeilenwähler ($P_1...P_n$ vorgesehen ist, der je zwei, in der Phase gegeneinander versetzte Signalausgänge je Wählschritt aufweist, die jeweils eine Schreibwortleitung (ws) bzw. eine Lesewortleitung (wl) ansteuern, welche je Zeile der Matrix vorgesehen sind,

-daß je Spalte zwei getrennte Bitleitungen, nämlich eine Schreibbitleitung (bs) und eine Lesebitleitung (bl) vorgesehen sind, die jeweils mit allen Speicherzellen einer Spalte zusammengeschaltet sind,

-daß je Spalte ein von der Lesebitleitung abtrennbarer, speichernder Verstärker ($A_1$...$A_m$) vorgesehen ist, dessen Eingang (i) mit der Lesebitleitung (bl) der ihm zugeordneten Spalte und dessen Ausgang (o) mit der Schreibbitleitung - (bs) der ihm nachgeordneten Spalte verbunden ist und als ein ihm zugeordneter Datenausgang ($Z_1$...$Z_m$) dient,

-daß ein Dateneingang für die zu verzögernden Bildsignale mit der Bitschreibleitung (bs) der ersten Spalte und einem unverzögerten Datenausgang ($Z_o$) verbunden ist,

-daß ein Rücksetzeingang ($\overline{\text{Reset}}$) mit Setzeingängen (a, $\overline{s}$) eines ersten Gliedes ($P_1$) des Zeilenwählers sowie mit den Rücksetzeingängen ($\overline{r}$) der restlichen Glieder ($P_2$....$P_n$) des Zeilenwählers verbunden ist,

-daß der zeitliche Abstand zwischen Rücksetzimpulsen ($\overline{\text{Reset}}$) derart gewählt wird, daß er gleich der geforderten Verzögerungszeit ist, welche zwischen dem unverzögerten Datenausgang ($Z_o$) und dem ersten verzögerten Datenausgang ($Z_1$) eingestellt werden soll,

- daß entsprechend der Wortbreite der Bilddaten eine Vielzahl von derartigen matrixförmigen Speicheranordnungen, nämlich Speicherblöcke (z.B. $SP_o$...$SP_7$) vorgesehen sind, für die der Zeilenwähler ($P_1$...$P_n$) gemeinsam angeordnet ist, wobei jeweils ein Speicherblock ein Bit des Bilddatenwortes aufnimmt und als das jeweils entsprechende Bit von mehreren, unterschiedlich verzögerten Ausgangsdatenwörtern $O_o$...$O_n$ ) bereitstellt,

-daß eine arithmetische Einheit vorgesehen ist, in der Datenausgänge ($O_o$...$O_m$) zum Erreichen der geforderten Filterfunktion in einer Anordnung kaskadierter Verknüpfungsglieder derart verknüpft, d.h. addiert bzw. subtrahiert, werden, daß zunächst zwei Ausgänge ($O_i$) mit den betragmäßig kleinsten Koeffizienten miteinander verknüpft werden, das Resultat nach gegebenenfalls entsprechend der Filterfunktion erforderlicher Gewichtung mit dem Ausgang ($O_i$) mit dem betragsmäßig nächstgrößeren Koeffizienten verknüpft wird, das Resultat gegebenenfalls wiederum gewichtet wird u.s.f. und

-daß zum Anpassen sich unterschiedlich ergebender Laufzeiten in dieser kaskadierten Anordnung digitale Verzögerungsglieder (T) an entsprechenden Stellen vorgesehen sind.

2. Schaltungsanordnung nach Anspruch 1, dadurch **gekennzeichnet,** daß ein Reset-Signal, das dem Rücksetzeingang ( $\overline{\text{Reset}}$ ) zugeführt wird, mit den Eingangssignalen bereitgestellt wird.

3. Schaltungsanordnung nach einem der vorhergehenden Ansprüche, dadurch **gekennzeichnet,** daß aus der Schaltungsanordnung nur diejenigen Datenausgänge herausgeführt sind, die für die Filterfunktion der Schaltungsanordnung erforderlich sind.

4. Schaltungsanordnung nach Anspruch 1, dadurch **ge-**

**kennzeichnet,**

-daß der Zeilenwähler ($P_1$...$P_o$) jeweils aus einem Schieberegister, einem Verknüpfungsblock und zwei Ausgangstreibern mit Ausgängen (ws bzw. wl) je Glied des Zeilenwählers besteht und

-daß die Phasenlagen und Impulsbreiten der Ausgangssignale in den Ausgängen (ws und wl) durch entsprechende Verknüpfungen dreier in dem Schieberegister vorhandener Abgriffe bewirkt werden.

5. Schaltungsanordnung nach Anspruch 1, dadurch **gekennzeichnet** , daß die arithmetische Einheit sog. Carry-Save-Addierer als Verknüpfungsglieder enthält, wobei die zu verknüpfenden Daten im Zweierkomplement dargestellt sind.

6. Schaltungsanordnung nach Anspruch 1, dadurch **gekennzeichnet,** daß in der arithmetischen Einheit sog. Carry-Ripple-Addierer als Verknüpfungsglieder enthalten sind, wobei die zu verknüpfenden Daten im Zweierkomplement dargestellt sind.

7. Schaltungsanordnung nach Anspruch 5, dadurch **gekennzeichnet** , daß die arithmetische Einheit derart organisiert ist,

-daß eine abschließende Aufbereitung der jeweils entstehenden Überträge (carries) durch einen sog. Pipeline-Paralleladdierer (Fig. 6) bewirkt wird, wobei der Pipeline-Paralleladdierer (PARADD) außer Halbaddierern (HA) an sich bekannte Verknüpfungsglieder ($\sigma$) für vier Eingangsvariable - ($G_{IN}$, $P_{IN}$, $G'_{IN}$ und $P'_{IN}$) und zwei Ausgänge ($G_{OUT}$ und $P_{OUT}$) mit den logischen Funktionen

$$G_{OUT} = G_{IN} \vee (G'_{IN} P_{IN})$$

$$P_{OUT} = P_{IN} \wedge P'_{IN}$$

enhält,

-daß zur Erzeugung des Resultats der i-ten Stelle in einer ersten Ebene jeweils paarweise die Eingangsvariablen $(i)_1$ mit $(i-1)_1$, $(i-2)_1$ mit $(i-3)_1$, $(i-4)_1$ mit $(i-5)_1$ u.s.f. nach diesen logischen Funktionen verknüpft werden,

-daß in einer zweiten Ebene die Resultate dieser Verknüpfungen wiederum als Eingangsvariable für paarweise Verknüpfungen $(i)_2$ mit $(i-2)_2$, $(i-4)_2$ mit $(i-6)_2$ u.s.f. nach diesen logischen Funktionen verknüpft werden,

-daß soviele Verknüpfungsebenen dieser Art vorgesehen sind, daß nur noch ein Resultat als Rest übrigbleibt,

-daß die Eingangsvariablen ($G_{IN}$, $P_{IN}$, $G'_{IN}$, $P'_{IN}$) für die erste Ebene durch eine Eingangsgruppe mit Halbaddierern - (HA) bereitgestellt werden, wobei die Eingangsvariablen - ($G_{IN}$, $P_{IN}$) durch die Halbaddierer-Ausgänge (G, P) der i-ten Stelle und die Eingangsvariablen ($G'_{IN}$, $P'_{IN}$) durch die Halbaddierer-Ausgänge (G, P) der (i-1)-ten Stelle gebildet werden u.s.w.

-daß die Summenbits, nämlich die Bits des Ausgangsdatenwortes, aus den Resultatbits der letzten Ebene von Verknüpfungsgliedern ($\sigma$) und Ausgangsvariablen der Eingangs-Halbaddierer-Gruppe so gebildet werden, daß der Halbaddierer (HA) der (i+1)-ten Stelle mit dem Ausgangssignal -

($G_{OUT}$) des Verknüpfungsgliedes ($\sigma$) der i-ten Stelle und dem Ausgangssignal (P) des Eingangs-Halbaddierers HA) der (i + 1)-ten Stelle belegt wird u.s.w. und

-daß die in diesem Verknüpfungsschema nicht benutzten Eingänge der Verknüpfungsglieder ($\sigma$) auf entsprechende feste Hilfspotentiale, nämlich $G'_{IN} = \emptyset$ und $P'_{IN} = 1$,

gelegt werden.

8. Schaltungsanordnung nach einem der vorhergehenden Ansprüche, dadurch **gekennzeichnet**, daß sie als monolithisch integrierte MOS-Schaltung realisiert ist.

0 193 836

# FIG 1

AUSSCHNITT AUS
EINEM FERNSEHBILD:

GEWICHTETE MITTELWERTBILDUNG
BENACHBARTER BILDPUNKTE IN ZWEI DIMENSIONEN

HORIZONTALFILTER —☐— SPEICHERT EINEN BILDPUNT

VERTIKALFILTER —☐— SPEICHERT EINE BILDZEILE

FIG2

FIG 3

# FIG4

# FIG5

# FIG 6

# FIG 7

# FIG 8

FIG 9a

# FIG 9b

FIG 10a

# FIG 10b

0 193 836

FIG 11

PARADD

# FIG 12

a

b

# FIG 13

a

b

# FIG 14

PARADD 1

PARADD 1

| | | | |
|---|---|---|---|

---

Europäisches Patentamt

**EUROPÄISCHER RECHERCHENBERICHT**

Nummer der Anmeldung

EP 86 10 2391

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-3 893 088 (BELL) <br> * Figuren 10A,5A; Spalte 17, Zeile 44 - Spalte 18, Zeile 43 * <br> --- | 1,4 | G 11 C 8/00 <br> H 03 H 17/06 |
| A | EP-A-0 031 950 (NEC CORP.) <br> * Figuren 13,16; Seite 21, Zeilen 17-23; Seite 22, Zeile 20 - Seite 23, Zeile 1 * <br> --- | 1,4 | |
| A | PROCEEDINGS OF THE 1979 INTERNATIONAL SYMPOSIUM ON CIRCUITS AND SYSTEMS, Tokyo, JP, 17. - 19. Juli 1979, Seiten 185-188, IEEE, New York, US; L. YONG-CHING et al.: "Linear phase FIR digital filter without multipliers" <br> * Zusammenfassung; Figuren 2,7,8 * <br> --- | 1 | |
| A | US-A-4 480 271 (COLEMAN, Jr.) <br><br> * Figuren 3,5; Spalte 9, Zeilen 29-60 * <br><br> ----- | | G 11 C <br> H 03 H |

RECHERCHIERTE SACHGEBIETE (Int. Cl.4)

Der vorliegende Recherchenbericht wurde für alle Patentansprüche erstellt.

| Recherchenort <br> DEN HAAG | Abschlußdatum der Recherche <br> 09-06-1986 | Prüfer <br> SONIUS M.E. |
|---|---|---|

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82